# EUROPÄISCHE PATENTANMELDUNG

(11) **EP 2 012 432 A2**
(43) Veröffentlichungstag der Anmeldung: **07.01.2009**
(21) Anmeldenummer: 08159711.4
(22) Anmeldetag: 04.07.2008
(51) Int. Cl.: H03K 17/16

(54) **FET-Tiefpass**

(30) Priorität: 04.07.2007 DE 202007009332 U
(71) Anmelder: Aizo AG, 35578 Wetzlar (DE)
(72) Erfinder: Beck, Winfried, 65191 Wiesbaden (DE)

(57) **Zusammenfassung**

Integriertes Schaltelement umfassend mindestens einen Feldeffekttransistor (1), eine mindestens ebensolche Anzahl an Ansteuerungsschaltvorrichtungen (12) für den mindestens einen Feldeffekttransistor (1), welches, um eine universell verwendbare Ansteuerschaltung zu bilden, sowie um die EMV-Gewährleistung sicherzustellen sowohl mindestens einen Feldeffekttransistor (1), als auch die mindestens eine Ansteuerschaltung (12) innerhalb einer einzigen integrierten Schaltung zusammenzufassen, indem das integrierte Schaltelement sowohl einen variabel einstellbaren ohmschen Widerstandswert. (13), angeordnet zwischen Feldeffekttransistor (1) und Ansteuerungsschaltvorrichtung (12) aufweist; sowie ein Stromnetz bzw. einen Verbraucher, welche diese integrierte Schaltung ausweisen, um so deren elektromagnetische Verträglichkeit (EMV) sicherzustellen.

## Beschreibung

### Stand der Technik:

Der Feldeffekttransistor, meist abkürzend als FET bezeichnet, ist ein unipolarer Transistor. Unipolar daher, weil im Gegensatz zum bipolaren Transistor, je nach Typ, entweder nur Defektelektronen (Löcher) oder Elektronen am Stromtransport beteiligt sind. Er umfasst die drei Anschlüsse, "Source", "Gate" und "Drain".
Beim Betrieb eines FET wird ein elektrisches Feld, meist zwischen Gate und Source, angelegt wodurch ein Stromfluss durch den leitenden Kanal (Source => Drain) des Feldeffekt-Transistors bewirkt wird. Der FET weist damit wesenhaft eine kapazitive Komponente auf, welche es erst ermöglicht, einen elektrischen Strom oder Spannung zu schalten.
Mit dem Gate lässt sich die Leitfähigkeit zwischen Drain und Source regulieren. Durch eine angelegte Spannung an der Steuerelektrode (Gate) wird das angelegte elektrische Feld beeinflusst. Je höher die Spannung zwischen Source und Gate ist, desto stärker leitet der FET zwischen Drain und Source. Mit einem Spannungsteiler vor dem Gate lassen sich Regelkreise aufbauen.

Der entscheidende schaltungstechnische Unterschied zum bipolaren Transistor besteht in der bei niedrigen Frequenzen praktisch leistungslosen Ansteuerung des FET; zu dessen Ansteuerung wird daher lediglich eine Steuerspannung und kein Steuerstrom benötigt. Der FET verbraucht daher außerdem bei niedrigen Frequenzen praktische keine Steuerleistung.

Ein weiterer Unterschied zum unipolaren Transistor ist der Ladungstransport in dem unipolaren Source-Drain-Kanal. Diese Tatsache ermöglicht prinzipiell einen inversen Betrieb des FET, d.h. Drain und Source können vertauscht werden. Zudem kann der unipolare Kanal als bidirektionaler Widerstand benutzt werden und somit nicht nur Gleich- sondern auch Wechselströme beeinflussen, Von diesem Umstand macht man insbesondere bei Dämpfungsschaltungen (Abschwächer, Muting) Gebrauch.

Der Fachmann unterteilt die ihm unter dem Sammelbegriff "Feldeffekt-Transistor" bekannten Typen in erster Linie in:
- Sperrschicht-Feldeffekt-Transistor (JFET)
- Schottky-Feldeffekt-Transistor (MESFET)
- Metalioxidhalbleiter-Feldeffekt-Transistor (MOSFET)
- High Electron Mobility Transistor (HEMT)
- Ionen-Sensitiver Feldeffekt-Transistor (ISFET)
- Organischer Feldeffekttransistor (OFET)
- Insulated Gate Bipolar Transistor (IGBT)

Die der Anmeldung zugrunde liegende Erfindung findet auf alle diese Feldeffekt-Transistoren Anwendung.

Ansteuerung von FETs:
Trägt man den Drain-Strom und die Drain-Source-Spannung übereinander in einem Koordinatensystem auf, so kommen die typischen Kennlinien eines FET aus einem Punkt, während sie beim bipolaren Transistor aus einem Stamm kommen. Hierbei steigen der Drain-Strom und die Drain-Source-Spannung bis zur so bezeichneten "Abschnürgrenze" linear an, wobei sich ab der Abschnürgrenze der Drain-Strom über der Spannung dann asymptotisch seinem Endwert nähert (angelehnt a). Jede Kennlinie gilt für eine bestimmte Gate-Spannung. Bei einer Gate-Spannung von 0V ist die Sperrschicht typischerweise am größten, bzw. der Leitwert am kleinsten. Hier fließt beim selbst sperrenden MOSFET der kleinste Strom I durch den Kanal und nimmt annähernd den Wert Null an. Ab der Abschnürgrenze lässt sich der Strom durch den Kanal nicht mehr erhöhen.

Zum Betrieb eines FETs wird eine Steuerspannung benötigt, die charakteristischerweise von einer vorgeschalteten Verstärkeranordnung, wie beispielsweise einem handelsüblichen Operationsverstärker bereitgestellt wird.
Da die bauartbedingte Kapazität eines FET zwischen Gate und Source, sowie diejenige zwischen Gate und Drain bei jedem FET-Typ anders ist, ist es schaltungstechnisch notwendig, wenn man den FET beispielsweise mit Hilfe eines universellen und preiswerten Standardverstärker ansteuern möchte, diesen universellen und preiswerten Standardverstärker mit Hilfe eines passenden ohmschen Widerstands an den jeweiligen individuellen FET anzupassen.

Aufgabe der Erfindung ist es daher, mindestens eine universell verwendbare Ansteuerschaltung für einen FET und mindestens einen FET in einer integrierten Schaltung so zusammenzufassen, dass beide möglichst breit einsetzbar sind.

Beim Schalten von Lasten mit Hilfe eines FET ist in der Praxis darüber hinaus zu beachten, dass jeder Schaltvorgang eine hochfrequente Störung verursachen kann, die sich in dem Leitungsnetz ausbreitet und andere an dieses Leitungsnetz angeschlossene Verbraucher stören kann. Um einen möglichst reibungsfreien, also erfolgreichen Betrieb solcher Verbraucher zu gewährleisten, gelten in bestimmten Anwendungsbereichen normativ festgelegte Grenzwerte für derartige Störaussendungen.

Damit ein solcher Transistorschalter die für den jeweiligen Anwendungsfall geltenden Grenzwerte derartiger Störaussendungen einhalten kann, wird im Stand der Technik als eine Möglichkeit vorgeschlagen, dem Schaltverhalten eine gewisse Trägheit aufzuprägen, sodaß die hochfreqenten Anteile des Schaltsignals verringert werden (Dämpfung).

Die gestellte Aufgabe umfaßt daher auch, eine Steuerschaltung bereitzsutellen, die geeignet ist, einen FET hinsichtlich seines EMV-Verhaltens zu optimieren, ohne daß hierbei das Schaltverhalten des FET beeinträchtigt wird.

Im Stand der Technik sind hinaus Verfahren bekannt, die hochfrequente Störanteile außerhalb des Transistors durch eine passive Filterung reduzieren, bzw. eliminieren. Diese Methode erfordert jedoch verhältnismäßig große und teure Bauteile, wodurch deren Integration in integrierte Schaltungen nicht möglich ist. Dies bringt es wiederum mit sich, dass keine universell einsetzbaren, integrierten Schaltungen aufbaubar sind.

Die Aufgabe wird durch die Merkmale des unabhängigen Anspruchs gelöst. Vorteilhafte Ausgestaltungen ergeben sich aus den Unteransprüchen.

Ein integriertes Schaltelement umfassend mindestens einen Feldeffekttransistor (FET), eine mindestens ebensolche Anzahl an Ansteuerungsschaltvorrichtungen für den mindestens einen Feldeffekttransistor, bewirkt durch diese Zusammenfassung von FET und Ansteuervorrichtung in einem gemeinsamen, das Schaltelement definierenden Gehäuse, dass die Vorzüge von FETs mit den Vorzügen einer universellen Steuerung kombiniert werden können. Hierdurch kann ein preiswertes und in großen Mengen produzierbares individuell einsetzbares elektronisches Bauelement in der Gestalt einer integrierten Schaltung entstehen. Dies wird erreicht durch einen in dem integrierten Schaltelement variabel einstellbaren ohmschen Widerstandswert, der zwischen Feldeffekttransistor und Ansteuerungsschaltvorrichtung angeordnet ist.
Hierdurch wird bewirkt, daß in einer integrierten Schaltung ein individueller ohmscher Widerstandswert zwischen Ansteuerungsschaltvorrichtung und FET eingestellt werden kann. Dies bringt den Vorteil mit sich, daß einerseits eine Anpassung der Ansteuerungsschaltvorrichtung auf den FET ermöglicht wird, was zur Folge hat, daß ein universell verwendbarer FET in die integrierte Schaltung eingebaut werden kann und auch eine universell verwendbare Ansteuerungsschaltvorrichtung. Dies bringt über die Preis-Mengen-Degression erhebliche ökonomische Vorteile im Vergleich zu individuell aufeinander abzustimmende FETs und Ansteuerungsschaltvorrichtungen. Darüber hinaus wird auf diesem Wege der Vorteil bewirkt, durch eine Änderung des Widerstandswerts in Kombination mit den unveränderbaren kapazitiven Eigenschaften zwischen Gate und Drain des FET, den FET mit seiner festgelegten kapazitiven Charakteristik breiter und universeller als bisher einsetzen bzw. nutzen zu können, beispielsweise als R-C-Glied.
So werden erfindungsgemäß die eingangs beschriebenen parasitären Kapazitäten des FET genutzt, indem durch Vorschaltung eines Widerstandswerts vor den Steuer-Gate-Anschluß in Verbindung mit den Kapazitäten des FET ein RC-Tiefpassfilter gestaltet wird, um auf diesem Wege eine erwünschte Dämpfung bzw. eine größere Trägheit des Schaltverhaltens zu erreichen, um beispielsweise das EMV-Verhalten des FET, bzw, des mit dem FET gebildeten Schaltelements zu optimieren.
Zusätzlich wird also hierdurch der Vorteil bewirkt, dass mit Hilfe des erfindungsgemäß einstellbaren ohmschen Widerstandswerts, der mit der unvermeidbaren Kapazität des FET zusammenwirkt, zusätzlich die Wirkung eines R-C-Filters, beispielsweise in Form eines Tiefpasses, bereitgestellt wird. Das Verhalten dieses Tiefpasses kann über die Einstellung des variablen Widerstands individuell festgesetzt werden.
Die Bereitstellung, Nutzung und individuelle Einstellung dieser zusätzlichen Filterwirkung in einem integrierten Schaltelement mit einem FET, wobei die bauartbedingte Kapazität des FET genutzt wird, ist ein wesentliches Element der vorliegenden Erfindung. Diese Nutzung der Kapazität eines FETs auf die erfindungsgemäße Weise zur gezielten Bereitstellung und Einstellung eines R-C-Glieds, bzw. die individuelle Anpassbarkeit eines derartig gestalteten R-C-Glieds, insbesondere wenn der zugehörige FET sich in einem integrierten Schaltelement befindet, stellt die Grundlage für völlig neue Anwendungsbereiche derartig aufgebauter integrierter Schaltelemente mit einem FET dar.

Gängige Anwendungen finden FETs traditionell bei:
- Analogschaltern (IC)
- Schalten von Wechselspannungen (z. B. Dimmer)
- Kons<antstroinquellc.

Ein solcher völlig neuer und beispielhafter Anwendungsbereich ist beispielsweise der Ersatz von insbesondere mit Spulen aufgebauten Dimmern zur Steuerung von Verbrauchern in einem Gebäudestromnetz. Derartige mindestens daumengroße aber erfahrungsgemäß handflächengroße Dimmvorrichtungen für Gebäudestromnetze aus dem Stand der Technik können mit Hilfe der zugrunde liegenden Erfindung durch ein nur wenige Millimeter großes erfindungsgemäßes integriertes Schaltelement ersetzt werden, was den Vorteil einer signifikanten Platzersparnis mit sich bringt. Durch diese Platzersparnis ergeben sich neue Anwendungsbereiche für Dimmer, wie beispielsweise die Integration eines Dimmers in das Gehäuse eines auch kleinen Verbrauchers.
Ein weiterer signifikanter Vorteil mit den damit verbundenen neuen Anwendungsbereichen ergibt sich aus der Möglichkeit der Miniaturisierung des Aufbaus entsprechender Applikationen. Hierdurch eröffnen sich für die erfindungsgemäße Schaltung weitere neue Einsatzgebiete wie beispielsweise in der Energiespartechnik, in der Lebensmitteltechnik, der Kältetechnik, der Luft- und Raumfahrtechnik.
Um diesen R-C-Filter individuell einstellen zu können, bzw. ihn auf den individuell verbauten FET mit dessen beispielsweise herstellungsbedingten Toleranzen und seine Ansteuerungsschaltvorrichtung einstellen zu können, bzw. um diese Kombination aus Ansteuerungsschaltvorrichtung, Filter und FET individuell auf den beabsichtigten Einsatzzweckhin anzupassen, wird der Widerstandswert variabel ausgestaltet.
Auf diese Weise ist es also wie beschrieben möglich, mindestens einen FET nicht nur mit seiner mindestens einen Ansteuerungsschaltvorrichtung in ein integriertes Schaltelement zusammenzufassen, sondern es ist hierdurch auch möglich, dieses Schaltelement durch den zwischen beiden geschalteten mindestens einen variablen Widerstandswert viel breiter einzusetzen, als es zuvor ohne den erfindungsgemäß gestalteten variablen Widerstandswert möglich war.
Durch diese technische Maßnahme konnte ein universelles integriertes Schaltelement für einen universellen Einsatz geschaffen werden, wodurch mit Hilfe der für die Kalkulation der Produktionskosten maßgeblichen Preis-Mengen-Degression neue Preisregionen und durch die hierdurch ermöglichte kostengünstigere. Produktion und auch durch das Zusammenfassen erhöhte Integrationsdichte von derartigen Bauelementen pro Fläche neue technische und ökonomische Einsatzbereich erschlossen werden.
Durch die flexible Einstellbarkeit kann das integrierte Schaltelement außerdem auch auf das EMV-Verhalten der Umgebung hin individueller als bisher angepasst werden, um auf diesem Weg durch eine individuelle Anpassung eine für den jeweiligen Einsatzzweck optimierte Filterleistung des R-C-Glieds zu erhalten.
Durch die Erhöhung der Integrationsdichte derartiger Schaltelemente auf kleinem Raum ist es auch möglich in engstem Raum eine für den Einsatzzweck individuelle EMV-Anpassung zu ermöglichen. Hierdurch ist es möglich, Baugruppen, welche eine EMV-Prüfung nicht bestanden haben, nicht als Ausschuss zu behandeln, sondern sie können mit Hilfe der erfindungsgemäßen Schaltung auf die zu erreichenden EMV-Normen angepasst werden.
Bei der erfindungsgemäß beschriebenen Tiefpassfilterung mit Hilfe des beschriebenen R-C-Glieds bestehen jedoch die gegenläufigen Effekte, daß mit zunehmend verbesserter Entstörung anderseits die Verlustleistung im FET zunimmt. Legt man Wert auf eine minimale Verlustleistung wird man daher die Entstörung nur so ausweiten, dass die gegebenen Grenzwerte für Störaussendungen eingehalten werden und umgekehrt. Hieraus ergibt sich für diverse Applikationen eine jeweils individuelle Kompromissfindung zwischen Entstörung und Verlustleistung.

Bisherige Schaltungslösungen lösten dieses Problem indem die zur Transistorschalter passenden Bauelementewerte einzeln ausgewählt werden mussten und individuelle Paarungen zusammengestellt werden mussten, was der Gestaltung einer integrierten Schaltung im Wege stand.

Wenn die Anzahl der Ansteuerungsschaltvorrichtungen der Anzahl der FETs entspricht, so ist es möglich, pro integriertem Schaltelement mit Hilfe einer minimalen Anzahl an zu integrierenden elektronischen Bauelementen auszukommen

Wenn das integrierte Schaltelement einen FET der Gattung MOSFET oder JFET ist so kann hiermit ein integriertes Schaltelement aufgebaut werden, welches zur Steuerung von der in Hausstromnetzen üblichen 110V oder 220V Wechselspannung eingesetzt werden kann, wodurch deren Einsatz in beispielsweise Gebäudestromnetzen möglich wird. Zur Lösung von Problemen im Kleinspannungsbereich wie z.B. EMV-Probleme, können beispielsweise auch JFET eingesetzt werden.

Wenn dass das integrierte Schaltelement als Ansteuerungsschaltvorrichtung 12 einen Leistungsverstärker umfasst, so kann hiermit ein integriertes Schaltelement aufgebaut werden, welches zum Steuern eine sehr geringe Leistung benötigt, wobei die Steuerung sowohl mit Wechselstrom als auch mit Gleichstrom erfolgen kann.

Wenn sich zwischen FET und Ansteuerungsschaltvorrichtung mindestens ein ohmscher Widerstand befindet, so kann hiermit ein integriertes Schaltelement aufgebaut werden, welches auf der einen Seite die Vorzüge einer universellen Ansteuerungsschaltvorrichtung, wie beispielsweise Bewährtheit oder preiswerte Herstellung, nützt und auf der anderen Seite die Vorzüge eines FET nützt, wie beispielsweise eine so verlustarm, wie technisch mögliche Schaltung von Wechselströmen bzw. Wechselspannungen. Zusätzlich kann mit Hilfe des ohmschen Widerstands, der mit der unvermeidbaren Kapazität des FET zusammenwirkt, ein dem Fachmann vom Prinzip her bekannter R-C-Filter beispielsweise in Form eines Tiefpasses aufgebaut werden. Alternativ können statt einem auch mehr als ein Widerstand geschalten werden. So können beispielsweise mehr als ein Widerstand entweder nur parallel, oder nur in Reihe oder parallel und in Reihe geschalten werden. Diese Akkumulation von Einzelwiderständen könnte dann mit Hilfe einer Logikschaltung geschalten werden, indem der jeweils passende Widerstandswert von der betreffenden Logikschaltung schalten wird.

Wenn die variable Einstellung mit Hilfe einer parallelen Anordnung ohmscher Einzelwiderstände ermöglicht wird, so kann hierdurch einerseits die Art und Anzahl der vorgesehenen Widerstände dazu eingesetzt werden, dass hierdurch der Einsatzzweck der integrierten Schaltung (z.B. für einen definierten Einsatzzweck) typisiert und beliebig gestaltet werden kann und es können durch eine derartige Schaltung genau diejenigen Widerstandswerte aus den bereits vorgegebenen Widerstalldswerten kombiniert werden, die für den individuellen Einsatzzweck des integrierten Schaltelements situativ erforderlich sind. Auf diesem Wege kann eine universale Grundschaltung durch Typisierung, also Auswahl der interessierenden Widerstandswerte, zu einer typisierenden integrierten Schaltung umgestellt werden. Dies hat den Vorteil, daß ausgehend von einem einzigen Grundmodul beliebige passende typisierte integrierte Schaltungen mit FETs aufgebaut werden können.

Wenn die variable Einstellung mit Hilfe einer parallelen Anordnung zusätzlicher Kapazitäten ermöglicht wird, so kann hierdurch die bauartbedingte Kapazität des FET durch Hinzufügen zusätzlicher Kapazitäten individuell einstellbar gestaltet werden. Hierdurch kann die bauartbedingte Kapazität mit Hilfe zusätzlicher Kapazitäten, die mit ersterem entweder parallel oder in Reihe oder beides geschalten werden können, genutzt werden. Hierdurch können analog zum erfindungsgemäßen Einstellen eines individuellen ohmschen Widerstandswerts auf die analoge Weise individuelle Kapazitätswerte eingestellt werden. Eine derart aufgebaute und individuell angepasste Kapazität kann mit Hilfe eines analog individuell angepassten ohmschen Widerstandswerts zu einem hierdurch individuell angepassten R-C-Glied zusammengefasst werden.

Wenn sich der variabel einstellbare ohmsche Widerstandswert innerhalb oder außerhalb des integrierten Schaltelements befindet, können für den Fall, dass sich die Einstellfunktion des ohmschen Widerstandswerts der integrierten Schaltung außerhalb befindet, die im integrierten Schaltelement befindlichen universell einsetzbaren Bauelemente von außerhalb mit Hilfe des dann von außen einstellbaren Widerstandswerts individuell auf einen geplanten Einsatzzweck hin eingestellt werden. Durch den Anschluß an einen Rechner kann beispielsweise auch eine softwarebasierte Einstellung erfolgen, wie sie dem Fachmann vom Prinzip her geläufig ist.
Für den Fall, dass sich der ohmsche Widerstand innerhalb des integrierten Schaltelements befindet, kann diese Einstellung mit. Hilfe einer rechnergestützten Einstellung über einen an dem integrierten Schaltelement vorzusehenden Schnittstelle erfolgen, für deren Ansprechen der Hersteller der integrierten Schaltung üblicherweise die passenden Werkzeuge liefert.

Wenn das integrierte Schaltelement zusätzlich für jeden FET mindestens eine Logik-Schaltung mit mindestens einer Eingabemöglichkeit und mindestens einer Ausgabemöglichkeit umfasst, wobei die Ausgabemöglichkeit zwischen Ansteuerungsschaltvorrichtung und FET diejenigen Widerstandswerte schaltet, die zuvor bei der Eingabemöglichkeit eingegeben wurden, so ist es hierdurch möglich, dass durch eine externe Eingabe eines Widerstandswerts, genau diejenigen Widerstandswerte geschälten werden, die notwendig sind, um das R-C-Glied individuell für einem vorgesehenen Einsatzzweck anzupassen, um somit den so durch das R-C-Glied einstellbaren FET individuell auf eine genau definierte Aufgabenlösung hin auszurichten. Die Ansteuerung der Eingabemöglichkeit kann hierfür auch von außerhalb des integrierten Schaltelements erfolgen.

Wenn zu der Anordnung ohmscher Widerstände eine zusätzliche Steuerlogik und/oder Regelungsvorrichtung vorgeschalten ist, so ist es hierdurch nicht nur möglich, Widerstandswerte aus den bestehenden Widerständen zu kombinieren, sondern mit Hilfe der Steuerlogik experimentell einen passenden Widerstandswert für einen Einsatzzweck zu ermitteln, bzw. einen genau passenden Wert einzuregeln, wenn von der erzielen Einstellwirkung z.B. mit Hilfe einer Regelungsvorrichtung an diese Regelungsvorrichtung ein entsprechendes Regelungssignal zurückgemeldet wird.

Wenn eine integrierte Schalteinheit mindestens zwei integrierte Schaltelemente umfasst, so können integrierte Schalteinheiten aufgebaut werden, welche eine Vielzahl erfindungsgemäßer integrierter Schaltelemente umfassen.

Wenn ein Hausstromnetz mindestens eine integrierte Schalteinheit und/oder mindestens ein integriertes Schaltelement umfasst, so kann an dieser Stelle hierdurch Strom und/oder Spannung des Haustromnetzes weitestgehend verlustfrei und abwärmefrei gesteuert oder geregelt werden, um mindestens einen daran angeschlossenen Verbraucher oder eine ganze Leitung zu steuern oder zu regeln.

Wenn ein Verbraucher mindestens eine integrierte Schalteinheit und/oder mindestens ein integriertes Schaltelement im Hausstromnetz umfasst, so kann im Verbraucher hierdurch Strom und/oder Spannung des Verbrauchers weitestgehend verlustfrei und abwärmefrei individuell gesteuert oder geregelt werden.

Wenn der Verbraucher ein Dimmer ist, so kann dieser weitestgehend verlustfrei und abwärmefrei individuell gesteuert oder geregelt werden.

Hierdurch ist es möglich, sowohl in einem Stromnetz als auch bei jedem seiner Verbraucher, welches / welcher diese erfindungsgemäße integrierte Schaltung aufweist, deren elektromagnetische Verträglichkeit (EMV) sicherzustellen bzw. diese Gewährleistung zu erhöhen, wobei die Schaltung adaptiv in einer integrierten Schaltung untergebracht ist. Hierbei ergeben sich durch die Erfindung Vorteile durch Größen- und Kostenersparnis, insbesondere durch den Wegfall großer passiver Entstörbauteile und Gleichteileprinzip in der Fertigung.
In diesem Zusammenhang sei darauf verwiesen, dass der Fachmann unter der EMV grundsätzlich auch die Störfestigkeit subsummiert, weswegen man im vorliegenden Verständnis statt des Begriffs "EMV" auch den Begriff "Störaussendung" oder "elektromagnetische Störaussendung" gleichbedeutend verwenden kann

Die Erfindung wird mit ihren Einzelheiten darüber hinaus auch in den Zeichnungen beschrieben. Es zeigen, ohne hierauf exklusiv beschränkt zu sein:
Fig. 1 die drei für Feldeffekttransistoren geläufigen Grundschaltungen,

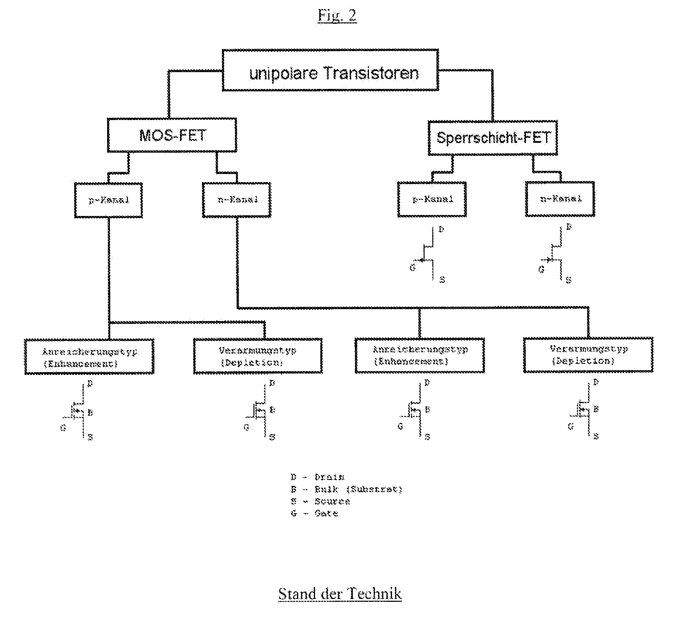

Fig. 2 einen Überblick über gängige Schalthauelemente, die gemäß der Erfindung eingesetzt werden können;
Fig. 3a,b eine erfindungsgemäße Schalung, verwirklicht mit Hilfe von parallel geschalteten Widerständen bzw. Kondensatoren;
Fig. 3c eine erfindungsgemäße Schaltung, verwirklicht mit Hilfe von in Reihe geschalteten Widerständen;
Fig. 4 Kennkurve eines für die Erfindung geeigneten Bauelement; vom Typ MOSFET IRF840;
Fig. 5 Screenshot der Kennkurve der Erfindung bei Verwendung zweier unterschiedlicher Widerstände.
Fig. 6 Kennkurve der Fig. 5 in abstrahierter Darstellung.

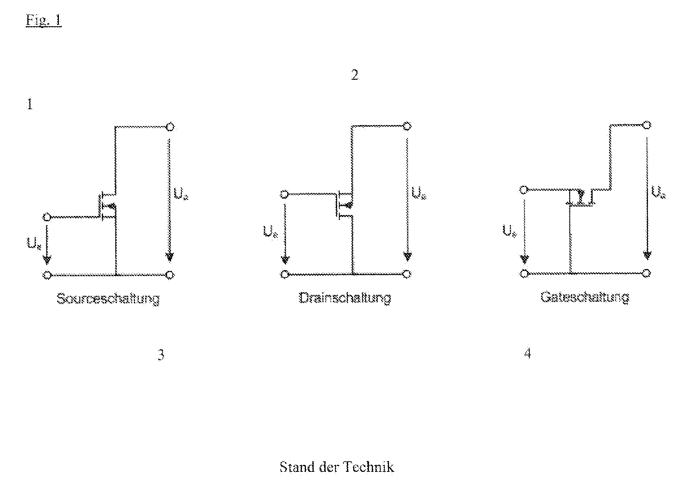

Fig. 1, beschreibt die drei Grundschaltungen für Feldeffekttransistoren, wie sie zum Zeitpunkt der Einreichung in Onlinelexika öffentlich zugänglich war. Prinzipiell umfasst der FET 1 die drei Anschlüsse:
Source 2 (Zufluß, Quelle),
Gate 3 (Tor) und
Drain 4 (Abfluss).

In Fig. 1a ist hierfür der FET 1 in einer Sourceschaltung, in Fig. 1b in einer Gateschaltung und in Fig. 1c in einer Drainschaltung dargestellt. Hierbei weist jeder der drei Darstellungen einen FET 1 mit seinem Gate 3, seiner Source 2 und seinem Drain 4 auf, wobei die Base je nach TFT-Typ intern verschalten wird. Die zugrunde liegende Erfindung ist für jede dieser Schaltungen anwendbar.

Beim MOSFET ist auch ein vierter Anschluss Bulk (Substrat) vorhanden. Dieser wird bei Einzeltransistoren bereits intern mit Source 2 verbunden und nicht extra herausgeführt.

Durch ein elektrisches Feld, hervorgerufen durch eine Steuerspannung zwischen Gate 3 und Source 2, wird die Leitfähigkeit des Soure-Drain-Kanals des Feldeffekt-Transistors beeinflusst.

Je nach benutztem Effekt wird unterschieden zwischen MOSFET und JFET (Junction- oder Sperrschicht-FET). JFETs nutzen einen in Sperrrichtung betriebenen p-n-Übergang, um das elektrische Feld zu bilden. Theoretisch kann dieser auch in Flussrichtung betrieben werden, was allerdings den für die zugrunde liegenden Erfindung wichtigen Vorteil der leistungslosen Ansteuerung zunichte machen würde.

Der entscheidende schaltungstechnische Unterschied zum bipolaren Transistor besteht in der bei niedrigen Frequenzen praktisch leistungslosen Ansteuerung des FET, wobei dann lediglich eine Steuerspannung benötigt wird.

Ein weiterer Unterschied ist der Ladungstransport in dem unipolaren Source-Drain-Kanal, Diese Tatsache ermöglicht prinzipiell einen inversen Betrieb des FET, d.h. Drain 4 und Source 2 können vertauscht werden. Allerdings trifft dies nur auf sehr wenige FETs zu, weil die meisten Typen sowohl unsymmetrisch aufgebaut als auch die Anschlüsse Bulk 5 und Source 2 intern verbunden haben.

Zudem kann der unipolare Kanal als bidirektionaler Widerstand benutzt werden und somit nicht nur Gleich-, sondern auch Wechselströme beeinflussen, was z.B, bei Dämpfungsschaltungen (Abschwächer, Muting) genutzt wird.

Der FET 1 weist wesenhaft eine Kapazität zwischen Gate 3 und Source, und hierdurch automatisch auch zwischen Gate 3 und Drain 4 auf.

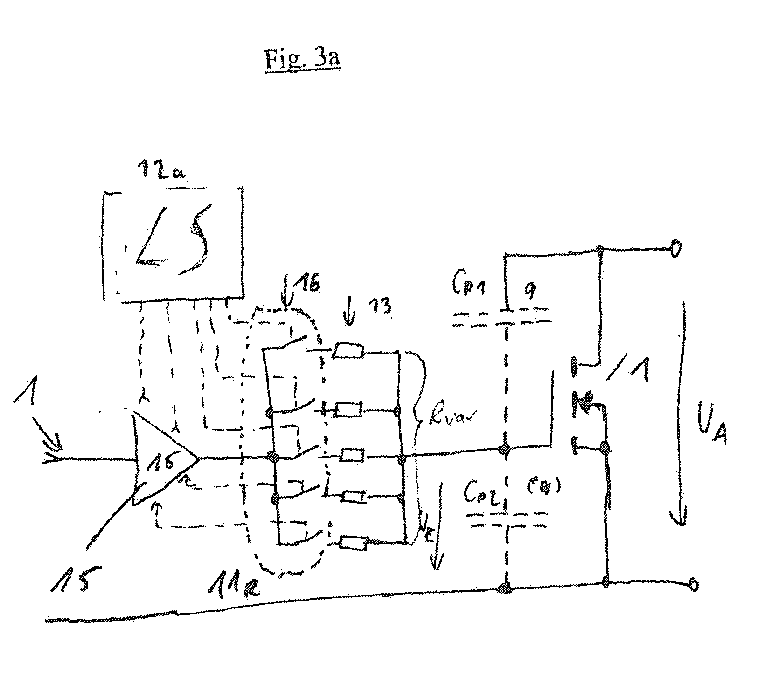

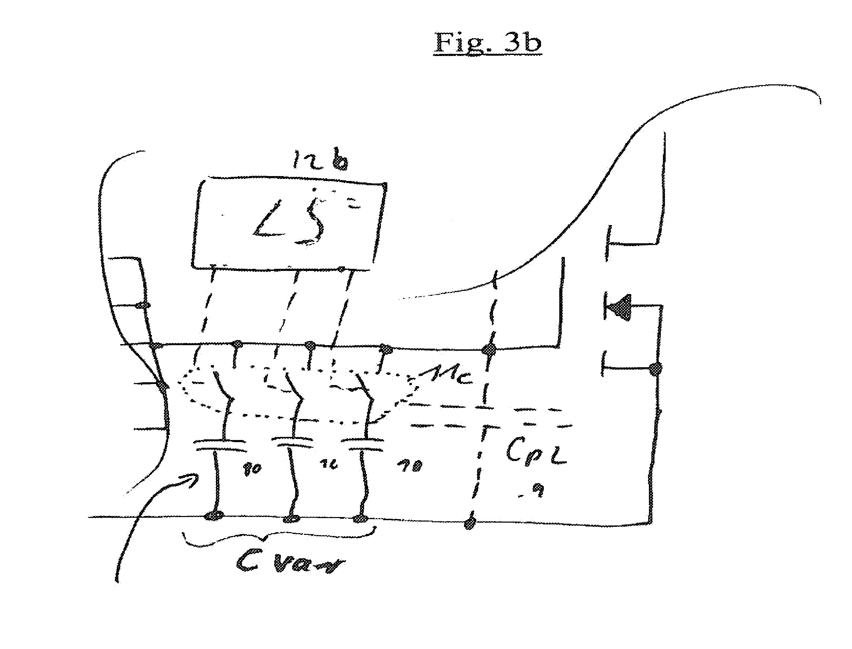

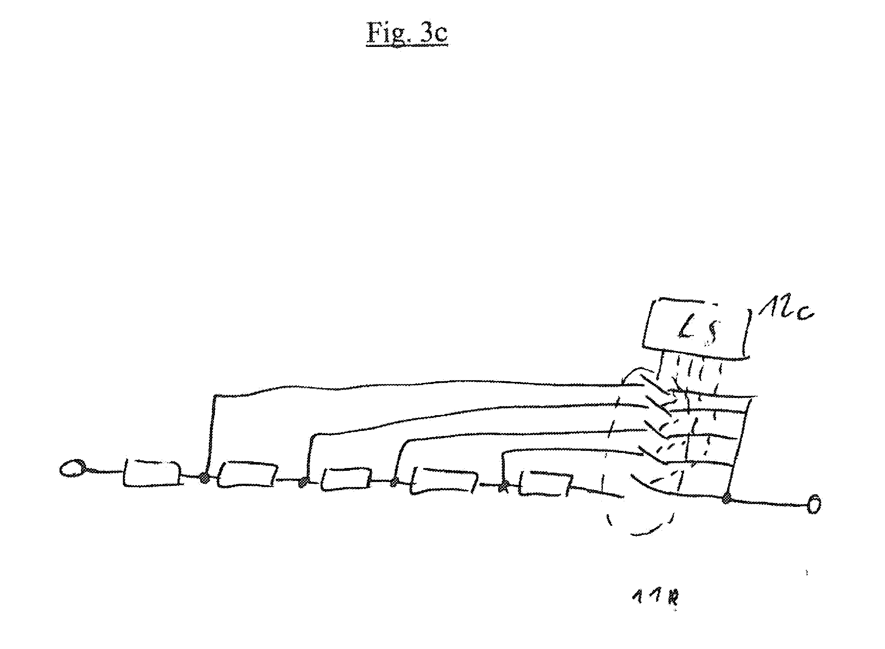

Diese Kapazität ist in den Fig. 3 durch die gestrichelt gezeichnete Kapazität Cp1; Cp2 9 symbolisiert. Der jeweils korrekte Betrag dieser Kapazität ist vom Typ des FET 1 abhängig, Erfindungsgemäß kann der Betrag dieser Kapazität durch zusätzliche Kapazitäten variiert werden, indem mindestens ein zusätzlicher Kapazitätswert Cᵥₐᵣ 10 zu der bestehenden Kapazität parallelgeschalten wird. Dieser zusätzliche Kapazitätswert Cᵥₐᵣ 10 kann auf erfindungsgemäße Weise aus diversen Einzelkapazitäten bestehen, indem beispielsweise Einzelkapazitäten Parallel- oder in Reihe- und/oder Parallel- und in Reihe- gleichzeitig geschahen werden. Hierbei kann erfindungsgemäß eine individuell gewünschte Kapazität eingestellt werden.
Die derart bereitgestellten zusätzlichen Kapazitäten können sowohl mit dem FET 1 in einer integrierten Schaltung in einem Gehäuse eingegossen sein, als auch außerhalb eines derartigen Gehäuses bereitgestellt werden, wobei dann die betreffende Anschlußstifte aus dem Gehäuse der integrierten Schaltung herausgeführt werden.
Die individuell gewünschte Kapazität kann erfindungsgemäß durch eine Einstellvorrichtung bewirkt werden. Eine klassische Möglichkeit eine derartige Einstellvorrichtung zu gestalten ist, eine variable Kapazität vorzusehen, bei welcher die gewünschte Kapazität von Hand eingestellt wird. Eine erfindungsgemäß alternative Möglichkeit ist, eine Ansteuerung mit Hilfe einer Steuervorrichtung, welche nach einer Eingabe durch einen Bediener genau diejenigen Kapazitäten so zusammenschaltet oder einstellt oder einregelt, dass hierdurch die individuell gewünschte Kapazität für den FET 1 bereitgestellt wird. Dies kann beispielsweise durch die in Fig. 3a; 3b; 3c dargestellten Schalteretemente 11C: 11R bewirkt werden, die beispielsweise durch eine LogikschaltungC (LS) 12 a; 12 b; 12 c angesteuert werden.

Das gleiche erfindungemäße Aufbauprinzip wie eben für Kapazitäten beschrieben, kann auch auf ohmsche Widerstände übertragen werden, wie in Fig. 3a und 3c dargestellt. Fig. 3a stellt ein integriertes Schaltelement dar, umfassend einen Feldeffekttransistor vom Typus MOSFET, und eine ebensolche Anzahl an Ansteuerungsschaltvorrichtungen 15, die durch ein Steuersignal 2 gespeist wird, für den einen Feldeffekttransistor. Durch diese Zusammenfassung wird bewirkt, dass die Vorzüge von FETs mit den Vorzügen einer universellen Steuerung kombiniert werden können, so dass hieraus ein preiswertes und in großen Mengen produzierbares individuell einsetzbares elektronisches Bauelement entsteht. Dies wird erreicht durch die Möglichkeit einen, zwischen den im integrierten Schaltelement befindlichen Feldeffekttransistor und Ansteuerungsschaltvorrichtung, angeordneten ohmschen Widerstandswert 13 variabel einzustellen. Auf diesem Wege kann ein individueller ohmscher Widerstandswert 13 zwischen Ansteuerungsschaltvorrichtung und FET 1 eingestellt werden um so einerseits eine Anpassung der Ansteuerungsschaltvorrichtung auf den FET 1 zu ermöglichen und darüber hinaus auch durch eine Änderung des Widerstandswerts 13 in Kombination mit dessen unveränderbaren kapazitiven Eigenschaften zwischen Gate 3 und Drain, sowie Gate und Source den FET 1 mit seiner festgelegten kapazitiven Charakteristik universeller als bisher einsetzen zu können.

So kann auf diesem Wege ein gewünschter Widerstandswert 13 individuell eingestellt werden.
Eine klassische Möglichkeit eine derartige Einstellvorrichtung zu gestalten ist, einen variablen Widerstand (z.B. Potentiometer) vorzusehen, bei welchem der gewünschte Widerstandswert 13 von Hand eingestellt wird. Eine erfindungsgemäß alternative Möglichkeit ist, eine Ansteuerung mit Hilfe einer Steuervorrichtung, welche nach einer Eingabe durch einen Bediener genau diejenigen Kapazitäten so zusammenschaltet oder einstellt oder einregelt, dass hierdurch der individuell gewünschte Widerstandswert 13 für den FET 1 bereitgestellt wird. Dies kann beispielsweise durch die in Fig. 3a; dargestellten Wiederstandswerte 11 R bewirkt werden, die beispielsweise durch eine LogikschaltungR (LS) 12 a; 12 c angesteuert werden. Alle diese Varianten können sowohl in einer integrierten Schaltung integriert sein, oder sich auch außerhalb einer integrierten Schaltung befinden.

In jedem Fall ist es hierdurch möglich, einen FET 1 viel flexibler und breiter anzusteuern, als bisher. Durch diese breitere Einsetzbarkeit können äußerst flexibel einsetzbare integrierte Schaltungen aufgebaut werden, wodurch es nicht nur sinnvoll ist, gleichartige FETs in einer integrierte Schaltung zusammenzufassen, sondern auch unterschiedliche FETs, da diese ja aufgrund der erfindungsgemäßen Schaltung viel breiter einsetzbar sind. So sind nun auch Integrierte Schaltungen wirtschaftlich einsetzbar, welche eine Breitbandanwendung ermöglichen, indem FETs derart in einer integrierten Schaltung zusammengefasst werden, dass sich ihre Einsatzbereiche mit bzw. ohne die erfindungsgemäße Schaltung leicht überlappen. Der Überlappungsbereich kann mit Hilfe der erfindungsgemäßen Schaltung jeweils voreingestellt werden.

Durch die auf diese Weise mögliche Konzentration von FETs auf engem Raum bzw. ihrer erweiterten Einsatzbreite eröffnen sich völlig neue Einsatzbereiche für Integrierte Schaltungen mit FETs. Beispielsweise können hierdurch mindestens eine Steuerung und mindestens ein FET 1 in eine Glühbirne oder eine Leuchtstoffröhre integriert werden, bzw. in deren Fassung oder Sockel.

Wenn nun der Kapazitätswert 10 mit dem Widerstandswert 13 zusammenwirkt, weil der einstellbare Widerstandswert 13 mit dem wesenhaft im FET 1 bereits vorhandenen und ggf. mit zusätzlichen Kapazitäten wie oben beschrieben zusammenwirkt, so kann hierdurch ein dem Fachmann vom Prinzip her bekanntes R-C-Glied aufgebaut werden. Wesentlich an diesem erfindungsgemäß aufgebauten R-C-Glied ist, dass hierbei die dem FET immanente Kapazität genutzt wird, wodurch Bauteile eingespart werden können. Hierdurch wird bewirkt, dass mit Hilfe des ohmschen Widerstandswerts 13, der mit der unvermeidbaren Kapazität des FET 1 zusammenwirkt, zusätzlich die Wirkung eines R-C-Filters, beispielsweise in Form eines Tiefpasses, bereitgestellt werden kann.
Die Bereitstellung, Nutzung und individuelle Einstellung dieser zusätzlichen Filterwirkung in einem integrierten Schaltelement mit einem FET, wobei auf die bauartbedingte Kapazität des FET 1 genutzt wird, ist damit ein wesentliches Element der vorliegenden Erfindung.
Die Nutzung der Kapazität eines FETs zur gezielten Bereitstellung eines R-C-Glieds, bzw. die individuelle Anpassbarkeit eines derartig gestalteten R-C-Glieds, insbesondere wenn der zugehörige FET 1 sich in einem integrierten Schaltelement befindet, bildet auch die Grundlage für völlig neue Anwendungsbereiche derartig aufgebauter integrierter Schaltelemente. Ein solcher völlig neuer Anwendungsbereich ist der Ersatz von insbesondere mit Spulen aufgebauter Dimmer zur Steuerung von Verbrauchern in einem Gebäudestromnetz. Derartige mindestens daumengroße aber erfahrungsgemäß handflächengroße Dimmvorrichtungen für Gebäudestiomnetze können mit Hilfe der Erfindung durch ein wenige Millimeter großes erfindungsgemäßes integriertes Schaltelement ersetzt werden. Neben der Platzersparnis ergibt sich der zusätzliche Vorteil, dass sich auch die Verlustleistungen beim Einsatz dieser erfindungsgemäßen integrierten Schaltelemente reduzieren lassen.
Auf diese Weise ist es möglich, einen FET 1 nicht nur mit seiner Ansteuerungsschaltvorrichtung in ein integriertes Schaltelement zusammenzufassen, sondern es ist hierdurch auch möglich. dieses Schaltelement durch den variablen Widerstand viel breiter einzusetzen, als es zuvor ohne den variablen Widerstand möglich war. Durch diese technische Maßnahme konnte ein universelles integriertes Schaltelement für einen universellen Einsatz geschaffen werden, wodurch mit Hilfe der für die Kalkulation der Produktionskosten maßgeblichen Freis-Mengen-Degression neue Preisregionen und durch die hierdurch ermöglichte kostengünstigere Produktion und auch durch das Zusammenfassen erhöhte Integrationsdichte von derartigen Bauelementen pro Fläche neue technische und ökonomische Einsatzbereich erschlossen werden.

Durch die flexible Einstellbarkeit kann das integrierte Schaltelement außerdem auch auf das EMV-Verhalten der Umgebung hin individueller als bisher angepasst werden als es bisher möglich war, um auf diesem Weg durch eine individuelle Anpassung eine für den jeweiligen Einsatzzweck optimierte Filterleistung des R-C-Glieds zu erhalten.

Auf diese Weise ist es möglich, dass mit Hilfe einer Logik-Emgabevorrichtung, die auch ein Computer sein kann, eine einfache Umschaltung oder auch eine Regelungsschaltung, wie beispielsweise die Logikschaltungen LSR und LSC geschalten werden können. Hierdurch kann die Logikschaltung LSR und LSC jeweils so geschalten werden, dass durch diese der jeweils angezielte Kapazitäts- und/oder Widerstandswert eingestellt werden kann.

Beispielsweise wurden gute Erfahrungen mit einer derart aufgebauten Integrierten Schaltung gemacht, welche einen FET1 des Typs SPU04N60C3 (Hersteller Infineon) bereitstellt, wobei diesem ein Widerstandswert 13 von 82KOhm vorgeschalten wurde, der aus Einzelwiderständen von 47KOhm, 82K.Ohm, 150KOhm auf die erfindungsgemäße Weise zusammengeschalten wird. Eine derart aufgebaute integrierte Schaltung wurde erfolgreich in eine Fassung bzw. Sockel eines Beleuchtungsmittels, wie z.B. einer Glühbirne eingesetzt, wodurch das Beleuchtungsmittel dimmbar wurde, ohne durch die Dimmung eine unzulässige EMV-Störung zu erzeugen, wobei keinerlei zusätzliche passive Filterung eingesetzt werden mußte (also keine Entstörkondensatoren, oder Entstördrosseln). In der hierdurch möglichen Vermeidung von Entstörkondensatoren, oder Entstördrosseln, bei gleichzeitiger Sicherstellung einer Vermeidung unzulässiger EMV-Störungen liegt einer der großen Vorteile der zugrundeliegenden Erfindung. Durch die Erhöhung der Integrationsdichte derartiger Schaltelemente auf kleinem Raum ist es auch möglich in engstem Raum eine für den Einsatzzweck individuelle EMV-Anpassung zu ermöglichen.

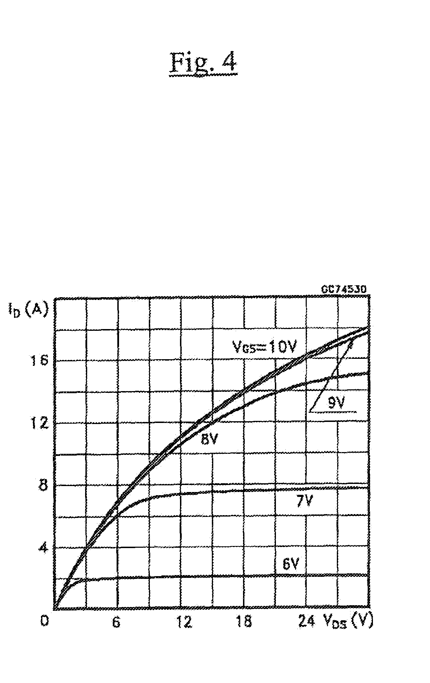

In Fig. 4 ist die Standard-Kennkurve eines für die erfindungsgemäß verwendeten MOSFET vom Typ IRF840 dargestellt.

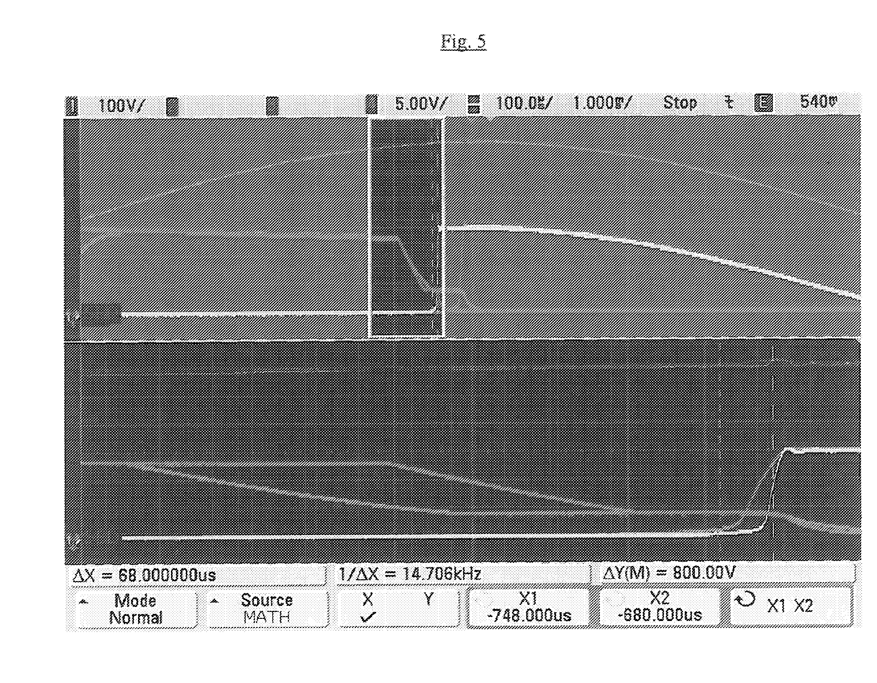

In Fig. 5 ist als Schreenshot das Zusammenwirken von Widerstandswert und kapazitivem Wert des FET als Tiefpass dargestellt. Hierbei werden im rechten unteren Eck zwei ansteigende Kurven gezeigt. Die hellere ansteigende Kurve (mit einem steileren Anstieg) zeigt direkt nach ihrem Anstieg ein deutliches Überschwingen, was auf ein unzureichendes Entstören hindeutet. Durch Einstellen eines in der integrierten Schaltung befindlichen Widerstandswert auf die erfindungsgemäße Weise, wurde eine saubere Entstörung erreicht, wie durch die zweite ansteigende Kurve ersichtlich ist.
Auf diesem Wege ist es erfindungsgemäß möglich die Entstörung eines FET individuell zu optimieren, selbst wenn er in einen IC eingebettet ist.

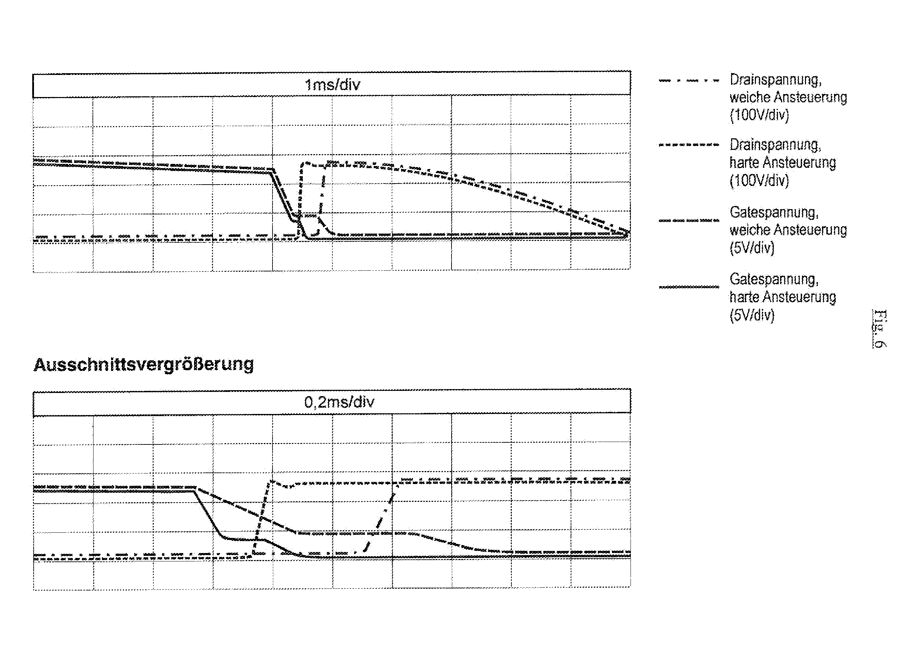

In Fig. 6 wird der Inhalt der Fig 5 noch einmal unter Vermeidung der Verwendung von Farben identisch wiedergegeben

## Patentansprüche

1. Integriertes Schaltelement umfassend mindestens einen Feldeffekttransistor (1), eine mindestens ebensolche Anzahl an Ansteuerungsschaltvorrichtungen (12) für den mindestens einen Feldeffekttransistor (1), einen variabel einstellbaren ohmschen Widerstandswert (13), angeordnet zwischen Feldeffekttransistor (1) und Ansteuerungsschaltvorrichtung (12).

2. Integriertes Schaltelement gemäß Anspruch 1 **dadurch gekennzeichnet, dass** die Anzahl der Ansteuerungsschaltvorrichtungen (12) der Anzahl der FETs (1) entspricht.

3. Integriertes Schaltelement gemäß Anspruch 1 oder 2 **dadurch gekennzeichnet, dass** das integrierte Schaltelement einen FET (1) der Gattung MOSFET oder JFET ist.

4. Integriertes Schaltelement gemäß einem der Ansprüche 1 bis 3 **dadurch gekennzeichnet, dass** das integrierte Schaltelement als Ansteuerungsschaltvorrichtung (12) einen Leistungsverstärker umfasst.

5. Integriertes Schaltelement gemäß einem der Ansprüche 1 bis 4 **dadurch gekennzeichnet, dass** sich zwischen FET (1) und Ansteuerungssehaltvorrichtung (12) mindestens ein ohmscher Widerstand (14) befindet.

6. Integriertes Schaltelement gemäß einem der Ansprüche 1 bis 5 **dadurch gekennzeichnet, dass** die variable Einstellung mit Hilfe einer parallelen Anordnung ohmscher Einzelwiderstände ermöglicht wird.

7. Integriertes Schaltelement gemäß einem der Ansprüche 1 bis 6 **dadurch gekennzeichnet, dass** die variable Einstellung mit Hilfe einer parallelen Anordnung zusätzlicher Kapazitäten (10) ermöglicht wird.

8. Integriertes Schaltelement gemäß einem der Ansprüche 1 bis 7 **dadurch gekennzeichnet, dass** sich der variabel einstellbare ohmsche Widerstandswert (13) innerhalb oder außerhalb des integrierten Schaltelements befindet.

9. Integriertes Schaltelement gemäß einem der Ansprüche 1 bis 8 **dadurch gekennzeichnet, dass** jeder FET (1) mindestens eine Logik-Schaltung mit mindestens einer Eingabemöglichkeit und mindestens einer Ausgabemöglichkeit umfast, wobei die Ausgabemöglichkeit zwischen Ansteuerungsschaltvorrichtung und FET (1) diejenigen Widerstandswerte (13) schaltet, die zuvor bei der Eingabemöglichkeit eingegeben wurden.

10. Integriertes Schaltelement gemäß einem der Ansprüche 1 bis 9 **dadurch gekennzeichnet, dass** der Anordnung ohmscher Widerstände eine Steuerlogik und/oder Regelungsvorrichtung vorgeschaltet ist.

11. Integrierte Schalteinheit, nach einem der Ansprüche 1 bis 10, **dadurch gekennzeichnet, dass** sie mindestens zwei anspruchsgemäße integrierte Schaltelemente umfasst.

12. Hausstromnetz nach einem der Ansprüche 1 bis 11, **dadurch gekennzeichnet, dass** es mindestens eine integrierte Schalteinheit, die einem der obigen Ansprüche entspricht und/oder mindestens ein integriertes Schaltelement, welches einem der obigen Ansprüche entspricht, umfasst

13. Elektrischer Verbraucher nach einem der Ansprüche 1 bis 12, **dadurch gekennzeichnet, dass** er mindestens eine integrierte Schalteinheit, die einem der obigen Ansprüche entspricht und/oder mindestens ein integriertes Schaltelement, welches einem der obigen Ansprüche entspricht, umfasst.

14. Elektrischer Verbraucher nach Anspruch 13, **dadurch gekennzeichnet, dass** der Verbraucher ein Dimmer ist.
